# EUROPEAN PATENT APPLICATION

(11) **EP 0 615 124 A1**
(43) Date of publication of application: **14.09.1994**
(21) Application number: 94102706.2
(22) Date of filing: 23.02.1994
(51) Int. Cl.: G01N 27/00, G01B 7/34, C30B 25/00

(54) **Method for in-situ growth of single crystal whiskers**

(30) Priority: 10.03.1993 US 29201
(71) Applicant: International Business Machines Corporation, Armonk, N.Y. 10504 (US)
(72) Inventor: Clabes, Joachim Gerhard, Yorktown Heights, New York 10598 (US); Fuentes, Ricardo Indalecio, Hopewell Junction, New York 12533 (US)
(74) Representative: Schäfer, Wolfgang, Dipl.-Ing.

(57) **Abstract**

The invention provides a single crystal tip which can be used, for example, for scanning the topography of a surface. The tip comprises a single crystal whisker having a sharpened end thereon, which can be mounted on an arm so that the tip extends away from the arm. A method of producing the tips/tip structures is also provided which utilizes the principles of a vapor-liquid-solid (VLS) mechanism.

## Description

### TECHNICAL FIELD

This invention relates to a method for in-situ growth of single crystal whiskers. The whiskers can be utilized as tips for scanning the topography of a surface, such as in scanning tunnelling microscopy. The tips can also be used as probes, sensors, or manipulators in the nanometer scale, or for any other application requiring in-situ grown, well defined structures. Such applications may involve the optoelectric properties of the whiskers, i.e. waveguides. The method utilizes a vapor-liquid-solid mechanism to localize and define the whiskers.

### BACKGROUND ART

Various microscopy and nano-fabrication techniques require a very sharp, well defined tip for operation. For example, a broad range of new microscopies have been developed which are commonly referred to as "SXM". SXM stands for Scanning X (= property to be probed) Microscopy. The common objective of each of these is to extend measurements to a very high lateral resolution which was not previously attainable with conventional means. The whisker structure of the subject invention enables the performance of such microscopies with a highly reproducible and stable tip structure.

It has also been widely recognized that small area probes, i.e., the whisker structure of the subject invention, can also be used to manipulate and modify materials on a length scale not in reach of conventional means. These problems have lead to a whole new field of nano-fabrication of structures, i.e., for storage, and new device concepts, i.e., the atomic watch.

In general whisker tips, particularly from silicon carbide, exhibit mechanical, chemical, structural, dielectric and electrical properties which are superior and more adaptable to specific applications than other tip materials commonly in use. Waveguides, emitters for computer displays, etc. represent a subset of technologies that could also benefit from the invention.

The accuracy and resolution obtainable in such applications depends critically on the detailed geometric shape of the tip. Other relevant characteristics of the tip structure are its chemical stability, mechanical stiffness and integrity, and electrical and optical properties. A process that can fabricate such structures with high reproducibility is crucial.

Tungsten wire has found broadest use as tip material. However, inherent in the fabrication process of tungsten tips is the uncontrolled tip geometry. This results in multiple protrusions which act as competing sites of interaction with the surface. Also, the chemical reactivity of tungsten makes the application of such tips limited to non-reactive environments.

Silicon, silicon carbide (SiC), and other materials have been grown as single crystals by the Vapor Liquid Solid (VLS) method [see R.S. Wagner and W.C. Ellis, Applied Physics Letters 4:89-90 (1964); and J.J. Petrovic et al., J. Materials Science 20:1167-1177 (1985)]. The method relies on the interaction of a vapor phase with a catalytic site on a substrate at an elevated temperature. The melt at the catalytic site becomes saturated with the components in the vapor. Crystal growth then takes place at the melt-substrate interface. The shape and size of the resulting growth is directly related to the area covered by the melt. The whiskers grow in length as long as the catalyst is present and the growth conditions are maintained.

The VLS mechanism has not been exploited for the purposes of growing very well defined and localized tip structures for applications such as microscopies, manipulation, fabrication, and optoelectronics. A principal advantage of the subject method is therefore the high resolution (nanometer scale) and accuracy with which the dimension and location of the whisker can be attained. This is defined and limited by the lithographic process step used to deposit the catalytic seed.

### DISCLOSURE OF INVENTION

It is thus an object of the invention to provide a tip structure for such applications which comprises a single crystal whisker with a sharp tip, mounted on an arm.

It is also an object of the invention to provide a method of producing such a tip structure, including a method which utilizes the VLS mechanism to provide a single crystal whisker to form the tip.

It is another object of the invention to provide such a method wherein the single crystal whisker growth is performed at a predetermined site on a support structure.

It is an additional object of the invention to provide a method of fabricating a tip structure of highly defined shape which is chemically inert and which has high aspect ratios.

In furtherance of these objectives, the present invention is directed to a single crystal tip which can be used, for example, for scanning the topography of a surface. The tip comprises a single crystal whisker having a sharpened end thereon. Preferably, the whisker comprises silicon carbide, although any material which can be grown by the VLS (vapor-liquid-solid) mechanism could, in principle, be used in this application. For example, silicon could also be used. A tip structure is provided by mounting the tip upon an arm, or growing it as an integral part of such an arm, such that the tip extends away from the arm.

The tips/tip structures are formed by a method which utilizes the principles of the VLS mechanism. Utilizing VLS, the tips/tip structures can be localized and defined on a substrate as heretofore was not possible. Specifically, the invention provides a method of producing a single crystal whisker grown as an integral part of a support structure. The method first comprises selecting a location on a substrate at which a single crystal whisker is desired to be grown. A broad variety of materials are suitable for use as the substrate provided they are compatible with the process conditions, such as the seed material used and the growth conditions. For example, a substrate which reacts with the seed material rendering the seed incapable of catalyzing whisker formation cannot be used. Similarly, a substrate which melts, distorts, or decomposes during processing cannot be used. For standard microfabrication, the use of single crystal silicon may be advantageous. Non-crystalline materials such as sintered aluminum oxide can also be utilized.

The placement of the catalyst seed can be performed by any method known to those skilled in the art. Standard or selective or a combination thereof, deposition processes can be used to place the seeds, in conjunction with or without lithography. For example, suitable methods include patterning of blanket films, laser, electron or ion beam deposition, writing by scanning tunneling microscopy (STM), and segregation or nucleation form unstable alloys or structures. Photoresist lift-off processes are one means of placing the catalyst seeds on the substrate. Large volume fabrication of these structures is possible by the application of the catalyst seeds in a pattern or array, which will enable simultaneous growth of a large number of integrated structures in a single process step. The catalyst seed itself can be any known to those skilled in the art. Metals are preferred, such as iron, chromium, or molybdenum, or their oxides. Other metals which are compatible (i.e., which will not evaporate or react in an indesirable way, etc.) with a high solubility of the whisker material (i.e., carbon and silicon) can also be utilized.

Once the catalyst seed has been located on the substrate, the substrate is placed in an environment containing the material precursors in a vapor phase. Such an environment could be, for example, a chamber in which conditions such as temperature, pressure, etc. can be regulated. One example of suitable conditions for whisker formation is 1,400° C under 1 atm of pressure with 0.4% CH₄-SiH₄-H₂.

To form the whisker, the catalyst seed is heated, preferably to about 1,400° C. This causes the vapor phase component, or material precursor, to react with the catalyst seed and form a liquid alloy with it. Laser heating allows for the confinement of this heating to a selected area, thus leaving adjacent areas unaffected. This allows the process to be used on substrates that would otherwise be incompatible with the process conditions. However, where ambient heating is appropriate, it can also be utilized. This could include, for example, placing the entire structure in an oven.

The location, as well as the dimensions, of the single crystal whisker are defined by the size and shape of the catalyst seed and process time. The diameter of the single crystal whisker can be defined by the diameter of the catalyst seed, and the length of the single crystal whisker can be defined by the length of time precipitation is allowed to occur. The diameter of the whisker can range from a couple microns to hundreds of microns, while the length of the whisker can range from a few microns to centimeters.

Processing conditions can be optimized so that the tip is formed on an arm, with numerous arms formed upon a substrate such as a silicon wafer, and the arms are subsequently separated to obtain separate tips/arms. Alternatively, the tips can be formed directly on a substrate, and the tips are subsequently separated, then mounted on arms. It should be readily apparent that the specific processing can vary to generate the single crystal whisker grown in-situ.

There may be additional process steps needed which will depend upon the specific application. Such steps may involve sharpening of the tips, which may be accomplished by ion milling, electrochemical etching, reactive ion etching, or other suitable means, such as mechanical treatments (cleavage, polish, or scribing), application of an electrical field (field emission or evaporation) or laser ablation and desorption. Other steps may involve coatings, sizing, mounting, or bonding, etc.

### BRIEF DESCRIPTION OF DRAWINGS

The foregoing and other objects, features and advantages of the invention will be apparent from the following more particular description of preferred embodiments of the invention as illustrated in the accompanying drawings in which:
- FIG. 1: is an isometric view of a substrate with catalyst seeds located thereon according to one embodiment of the method of the subject invention;
- FIG. 2: is a partially cut-away isometric view of a substrate with an arm defined thereon, and a catalyst seed located on the arm, according to another embodiment of the method of the subject invention;
- FIG. 3: is a partially cut-away isometric view illustrating whisker growth at the catalyst seed;
- FIG. 4: is a partial top view illustrating the arm, as defined on the substrate, subsequent to whisker growth;
- FIG. 5: is an isometric view of the arm, including the whisker, after separation from the remaining substrate; and
- FIG. 6: is an isometric view of the arm and the whisker after the whisker has been sharpened to a tip.

### BEST MODE FOR CARRYING OUT THE INVENTION

As mentioned previously, the broad concept of the subject invention is directed to the utilization of a vapor-liquid-solid (VLS) mechanism to produce tip structures of very well defined shape. Such tips can be utilized in microscopic techniques, including scanning tunneling microscopy, among other applications.

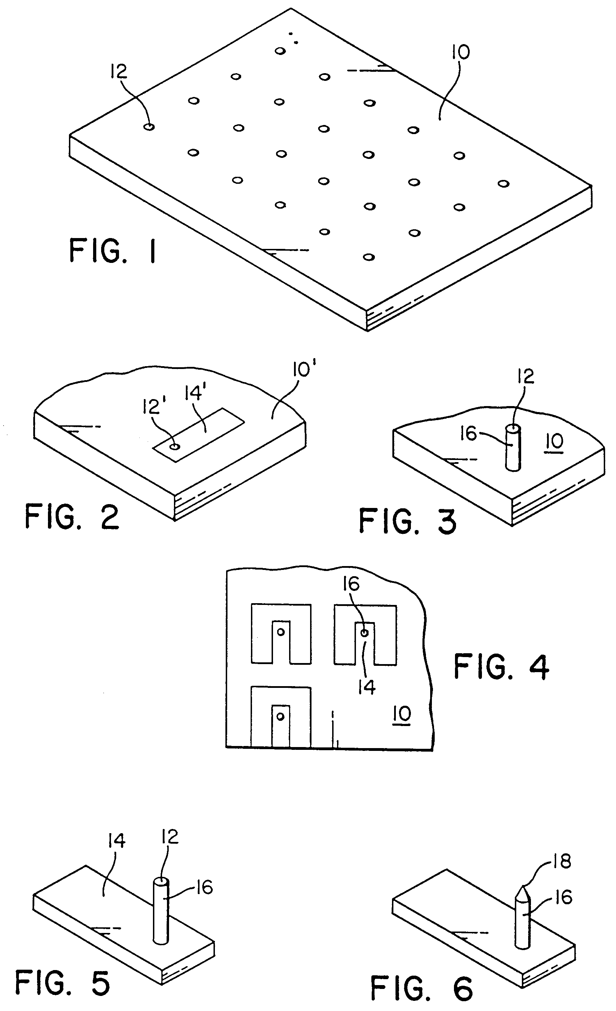

Reference is made to Figures 1-6 for a basic description of one embodiment of the method of the subject invention. With reference to Figure 1, a substrate 10 which could represent a silicon wafer is provided with a catalyst seed 12 at numerous locations thereon. The catalyst seed can be located by a variety of techniques known to those skilled in the art, as described above. The catalyst seed 12 may comprise iron or its oxides, or other suitable materials for the VLS process, as also discussed above.

In an alternate embodiment as shown in Figure 2, the catalyst seed 12' is located upon an arm 14' which has already been defined upon the substrate 10'. The definition of the arm can occur before or after growth of the whisker, depending upon desired processing parameters. The definition of the arm is discussed in further detail below. Examples of suitable methods for defining the arm include, for example, photolithography and selective etching. A wet etch using a solution of potassium hydroxide, or ethylenediamine, or ethylenediamine/pyrocatechol can be utilized as the selective etch, for example.

Referring now to Figure 3, substrate 10 is placed in suitable environmental conditions (such as in a chamber with controlled conditions) and heated. For the VLS mechanism to occur, the environmental conditions must include the components (or precursors) in a vapor phase which will subsequently precipitate out into the catalyst seed. As shown, the catalyst seed 12 is heated locally by a laser or with ambient heat and growth of whisker 16 occurs. The catalyst seed 12 remains on top of the forming whisker 16.

Growth of the whisker 16 is terminated by, for example, removing the precursors from the environment, or removing the catalyst seed, or removing the heat. Each of these will terminate whisker growth.

Referring to Figure 4, the substrate 10 is then patterned to define an arm 14 upon which the whisker 16 (including the catalyst seed on top) is located. Suitable lithography methods known to those skilled in the art can be utilized to define the arm. For practical purposes, it may be desirable to leave small connections between numerous arms formed from the same wafer, which can be diced to separate easily later on. Once separated, as shown in Figure 5, the arm 14 thus includes the whisker 16 with the catalyst seed 12 on top.

The whisker 16 can be sharpened at the end 18 (Figure 6) or modified for the specific application, with subsequent processes applied to the wafer or the individual elements. Suitable sharpening means include ion milling, for example. The final structure can then be used as a probe for microscopy, micromanipulation, fabrication, etc.

It is also possible to form whiskers by this method which are subsequently attached to a structure fabricated separately. However, it should be readily apparent that the preferred embodiment is to produce the whiskers with arms, since this extends the reproducibility and control of the fabrication of such structures to the nanometer range.

While the invention has been particularly shown and described with reference to preferred embodiments thereof, it will be understood by those skilled in the art that various changes in form and details may be made therein without departing from the spirit and scope of the invention.

## Claims

1. A single crystal tip comprising a single crystal whisker having a sharpened end thereon.

2. A tip structure comprising:
a single crystal whisker having a sharpened tip thereon; and
an arm upon which said single crystal whisker is mounted such that said tip extends away from said arm.

3. The tip or the tip structure of claim 1 or 2 wherein said single crystal whisker comprises a silicon whisker or silicon carbide.

4. The tip structure of claim 2 wherein said arm comprises silicon.

5. A method of producing a single crystal whisker in-situ which comprises:
selecting a location on a substrate at which a single crystal whisker is desired to be grown;
placing a catalyst seed at said location;
placing said substrate including said catalyst seed in an environment having a component in a vapor phase;
heating said catalyst seed such that said component in a vapor phase deposits into and forms a liquid alloy with said catalyst seed; and
precipitating said component in a solid phase from said liquid alloy at an interface between said solid phase and said liquid alloy, said precipitation of said solid phase comprising growth of a single crystal whisker at said location on said substrate.

6. The method of claim 5 wherein said single crystal whisker comprises a single crystal silicon or silicon carbide whisker and wherein said substrate comprises a silicon substrate.

7. The method of claim 5 or 6 wherein the diameter of said single crystal whisker is defined by the diameter of said catalyst seed, the diameter of said catalyst seed comprising the diameter of said single crystal whisker and wherein the length of said single crystal whisker is defined by the length of time of said precipitation, the length of time of said precipitation being proportional to the length in distance of said single crystal whisker.

8. The method of one or more of the preceding claims 5 to 7 wherein said catalyst seed comprises a metal.

9. The method of one or more of the preceding claims 5 to 8 wherein said placing of said catalyst seed comprises:
depositing a layer of catalyst on said substrate; and
removing portions of said layer of catalyst by a lithographic process, wherein remaining portions of said layer of catalyst which are not removed form said catalyst seed at said desired locations on said substrate.

10. The method of one or more of the preceding claim 5 to 9 wherein said environment comprises a chamber.

11. The method of one or more of the preceding claim 5 to 10 wherein said heating comprises laser heating of said catalyst seed and ambient heating of said substrate including said catalyst seed.

12. The method of one or more of the preceding claims 5 to 11 wherein said location on said substrate comprises an arm defined on said substrate said arm being defined by photolithography and selective etching comprising wet etching with a solution selected from the group consisting of potassium hydroxide, ethylenediamine, and ethylenediamine/pyrocatechol.

13. The method of one or more of the preceding claims 5 to 12 further comprising:
mounting said single crystal whisker so grown on an arm, said single crystal whisker so mounted having a tip extending away from said arm; and
sharpening said tip of said single crystal whisker wherein said sharpening comprises ion-milling.

14. A method of determining the contour of a surface which comprises:
moving said arm of claim 13 along a surface;
generating a current between the surface and the tip mounted on said arm;
determining the contour of the surface by analyzing the current so generated and generating a micrograph of said determined contour.

15. The method of claim 14 wherein said method comprises scanning tunnelling microscopy.
